# EUROPEAN PATENT SPECIFICATION

(11) **EP 4 152 084 B1**
(45) Date of publication and mention of the grant of the patent: **11.11.2026**
(21) Application number: 20897680.3
(22) Date of filing: 12.05.2020
(51) Int. Cl.: G09G 3/00, G02F 1/13, G02F 1/133

(54) **DISPLAY SUBSTRATE AND DISPLAY DEVICE**
ANZEIGESUBSTRAT UND ANZEIGEVORRICHTUNG
SUBSTRAT D'AFFICHAGE ET DISPOSITIF D'AFFICHAGE

(43) Date of publication of application: 22.03.2023
(73) Proprietor: BOE Technology Group Co., Ltd., Beijing 100015 (CN); Chengdu BOE Optoelectronics Technology Co., Ltd., Hi-tech Development Zone Chengdu Sichuan 611731 (CN)
(72) Inventor: DU, Mengmeng, Beijing 100176 (CN); DONG, Xiangdan, Beijing 100176 (CN); MA, Hongwei, Beijing 100176 (CN); LIU, Biao, Beijing 100176 (CN); ZHANG, Bo, Beijing 100176 (CN)
(74) Representative: Potter Clarkson
(86) International application number: PCT/CN2020/089818
(87) International publication number: WO 2021/226833

(56) References cited:
- EP-A1- 4 067 986
- CN-A- 103 901 641
- CN-A- 106 291 999
- CN-A- 109 961 727
- US-A1- 2016 379 906
- US-B2- 10 580 336

## Description

### TECHNICAL FIELD

The present disclosure relates to a field of display technologies, and in particular to a display panel and a display apparatus.

### BACKGROUND

With advancements of display technologies, Organic Light-emitting Diode (OLED) display apparatuses are one of hotspots in a research field of tablet display apparatuses, and OLED display light-emitting apparatuses have advantages of bright colors, good viewing angles, high contrast, fast response speed, bendable, and low power consumption, and the like, which have attracted people's attention. OLED display apparatuses, especially Active Matrix Organic Light-emitting Diode (AMLOED) display apparatuses, have broader application prospects in a future display field, and they have broad application space in multiple display fields such as mobile displays, vehicle displays, and medical displays.

In order to improve a product yield of the OLED display apparatuses, it may be necessary to perform some tests at different stages of producing processes of the display apparatus, and determine whether finished products or semi-finished products manufactured at current stage is qualified or not based on test results, and if they are not qualified, they may be repaired or discarded according to an actual situation. This manner may prevent the semi-finished products that have already had unqualified problems in previous stages from directly entering a next stage of the process without being processed, thereby saving costs and improving yield.

EP 4067986 A1 discloses a display substrate and a display device. The display substrate includes a base substrate, the base substrate includes a display region and a periphery region at least located at one side of the display region; a plurality of data signal transmission lines, a plurality of signal output pads, a plurality of signal input pads, and a plurality of test pads are located in the periphery region; a plurality of sub-pixels and a plurality of data lines are located in the display region; the plurality of data signal transmission lines are electrically connected with at least part of the plurality of data lines; the plurality of signal output pads and the plurality of signal input pads are configured to be bonded with a signal input element; the plurality of signal output pads are electrically connected with the plurality of data lines; the plurality of data signal transmission lines are electrically connected with at least part of the plurality of signal output pads; the periphery region is provided with a plurality of electrostatic release elements located between the plurality of signal output pads and the plurality of test pads, each of the plurality of electrostatic release elements is electrically connected with one data signal transmission line and is configured to release static electricity on the data signal transmission line.

US 2016/379906 A1 discloses that a display device includes a display panel with signal wire pads connected to data lines; an integrated circuit (IC) that feeds a data voltage to the data lines; a multiplexer disposed on a substrate of the display panel, between the data lines and the integrated circuit; a flexible circuit board bonded onto the substrate of the display panel and connected to the signal wire pads; and a test circuit on the substrate of the display panel.

### SUMMARY

The invention is set out by the appended set of claims.

### BRIEF DESCRIPTION OF THE DRAWINGS

Other features, purposes and advantages of the present disclosure will become apparent with reference to the description below to the non-limited embodiments with reference to the drawings:
FIG. 1 is a schematic view of the display substrate according to some embodiments of the present disclosure;
FIG. 2 is an enlarged schematic view of the integrated circuit device layout area in FIG. 1;
FIG. 3 is a schematic view of the integrated circuit device layout area of the display substrate according to some other embodiments of the present disclosure;
FIG. 4 is a schematic view of line connection relationships in the integrated circuit device layer area in FIG. 3;
FIG. 5 is an enlarged view of a section E in FIG. 2, and schematically shows a multiplexer in the display substrate according to some embodiments of the present disclosure;
FIG. 6 is a schematic cross-sectional view taken along line P-P in FIG. 5;
FIG. 7 is an enlarged view of a section F in FIG. 2;
FIG. 8 schematically shows a circuit principle diagram of an array test assembly on a display substrate according to some embodiments of the present disclosure;
FIG. 9 is a schematic cross-sectional view taken along line Q-Q in FIG. 7;
FIG. 10 is a schematic cross-sectional view taken along line K-K in FIG. 7;
FIG. 11 is a schematic view of a film layer structure of a display area on a display substrate according to the embodiments of the present disclosure;
FIG. 12 is a schematic view of a display apparatus according to the embodiments of the present disclosure; and
FIG. 13 shows a schematic view of an integrated circuit device layout area of a display substrate according to some further embodiments of the present disclosure.

### DETAILED DESCRIPTION OF EMBODIMENTS

The present disclosure will be further described in detail below with reference to the drawings and embodiments. It may be understood that the specific embodiments described herein are merely used to explain the related art, and should not limit the present disclosure. In addition, it should be noted that for ease of description, only parts related to the present disclosure are shown in the drawings.

It should be noted that the embodiments of the present disclosure and features in the embodiments may be combined with each other if there is no conflict.

In addition, in the detailed description below, for ease of description, many specific details are set forth to provide a comprehensive understanding of the embodiments of the present disclosure. However, it is obvious that one or more embodiments may also be implemented without these specific details.

It should be understood that although terms "first", "second" may be used to describe different elements here, however, these elements should not be limited by these terms. These terms are merely used to distinguish one element from another element. For example, without departing from the scope of the present disclosure, the first element may be named as the second element, and similarly, the second element may be named as the first element. The term "and/or" as used here includes any or all combinations of one or more related listed items.

It should be understood that when an element or a layer is referred to as being "formed on" another element or layer, the element or layer may be directly or indirectly formed on the another element or layer. That is, for example, there may be an intermediate element or an intermediate layer. In contrast, when an element or a layer is referred to as being "directly formed on" another element or layer, there is no intervening element or layer. Other terms used to describe the relationship (for example, "between" and "directly between", "adjacent" and "directly adjacent ", etc.) between elements or layers should be interpreted in a similar manner.

The terms used herein are only for a purpose of describing specific embodiments, and are not intended to limit the embodiments. As used herein, unless the context clearly dictates otherwise, the singular form is also intended to include the plural form. It should also be understood that when terms "comprising" and/or "including" are used herein, it means that the described features, wholes, steps, operations, elements and/or components are present, but the presence or addition of one or more other features, wholes, steps, operations, elements, components, and/or combinations thereof are not excluded.

In present disclosure, unless otherwise specified, expressions "located on the same layer" and "arranged on the same layer" generally indicate that the first component and the second component may use the same material and may be formed by the same patterning process. Expressions "located on different layers" and "arranged on different layers" generally indicate that the first component and the second component are formed by different patterning processes.

In a manufacturing process of a display panel, it is necessary to continuously detect quality problems of products, and timely screen out unqualified products during a test process, so as to adjust processes in time to realize a production with a high yield and a low cost. Since materials or components of a light-emitting layer and a driving integrated circuit, etc. are relatively expensive, electrical properties may be tested before evaporating light-emitting materials and binding a circuit device (such as an integrated circuit device, etc.), only if semi-finished products may meet quality requirements, they may enter a next stage of a process. Commonly used detection method to detect whether the electrical properties of the panel are defective or not before evaporating the light-emitting materials is called AT test (array test).

During the AT test, the test signal needs to be input into the TFT (thin film transistor) array in the display substrate to detect whether the electrical properties of each part of the display substrate meet the requirements or not, such as whether an on-off of a circuit is consistent with a design or not. For a COF encapsulated display panel, due to having a FPC (flexible circuit board), it is usually possible to directly access the test signal through cables of the flexible circuit board and input the test signal to the TFT array in the display substrate. However, as a demand for a narrow frame of the display panel becomes higher, for some display panels, the cables may no longer be arranged on the display substrate or the test signal may not be accessed to the TFT array only through the cables as desired due to a problem of a circuit connection relationship.

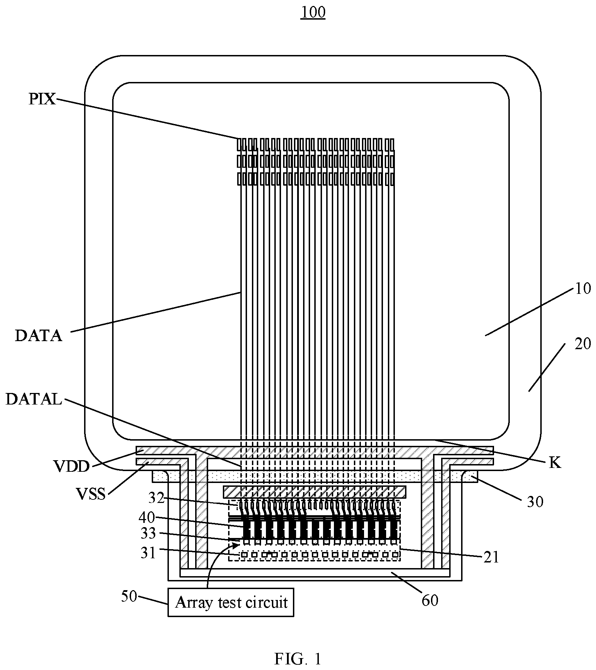

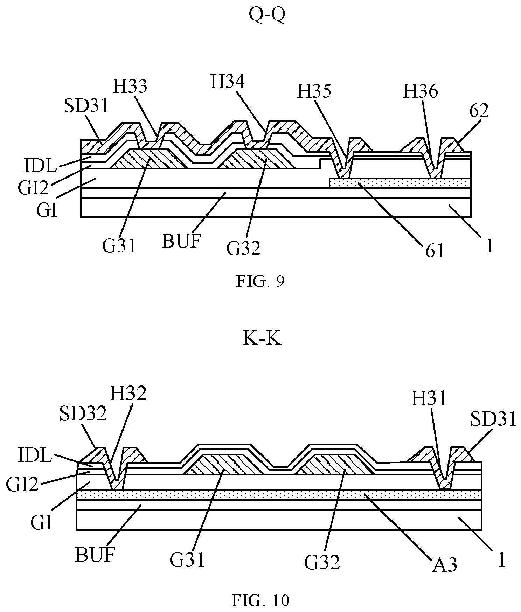

For example, FIG. 1 shows an example of the display substrate 100. The display substrate 100 is applied to a COP display apparatus. A display area 10 and a peripheral area 20 are provided on the display substrate. The display area 10 is used to display images, for example, the display area includes a plurality of sub-pixel units PIX (for example, the sub-pixel units may be arranged in an array). The peripheral area 20 is located at a periphery of the display area 10 (for example, may be arranged around the display area 10), and is used to lay out peripheral circuits (for example, a driving integrated circuit device, connection lines, etc.), and the like. A dimension of a frame of the display apparatus is limited by a size and a layout of the peripheral area 20 to a great extent. For a design of the display apparatus, in the peripheral area 20 on each side of the display area, there is usually an area of the peripheral area 20 integrating the most circuit elements, which requires a larger area. As shown in the example of FIG. 1, the peripheral area is located below the display area in FIG. 1. For reducing a restriction of the peripheral area to the narrowing of the frame of the display apparatus, the display substrate is provided with a bendable area 30 in the peripheral area 20. The bendable area 30 is flexible. In a final product, the bendable area 30 is bendable, so that a part of the peripheral area of the display substrate may be folded to a side of the display apparatus opposite to a display surface, thereby reducing a width of the frame. It should be understood that circuit structures in the display area 10 and the peripheral area 20 described above may be carried both on a base substrate 1 (with reference to FIG. 10). In the peripheral area 20, for example, a high-level signal line VDD and a low-level signal line VSS may be provided to provide level signals for an array test assembly 40. As an example, the peripheral area 20 may also be provided with an interface 60 coupled to the flexible print circuit board. A plurality of data lines DATA are also provided in the display area 10, and electrically coupled to a plurality of sub-pixel units PIX, respectively. The DATA lines are used to provide required data driving signals for each sub-pixel unit PIX. A plurality of data transmission lines DATAL (as shown by dashed lines in FIG. 1) are provided in the peripheral area 20 on at least one side of the display area 10 and are electrically coupled to the plurality of data lines DATA, respectively, for transmitting signals between the peripheral circuit and the data lines DATA of the display substrate.

A foldable portion of the display substrate is usually provided with an interface coupled to the external circuit of the display substrate and related lines. In the example of FIG. 1, the peripheral area 20 includes an integrated circuit device layout area 21, as shown by a dashed frame in FIG. 1. The integrated circuit device layout area 21 is used to lay out an integrated circuit device, and accordingly, a plurality of first pads 31 and a plurality of second pads 32 are provided in the integrated circuit device layout area 21. The plurality of first pads 31 and the plurality of second pads 32 may be used for bonding with the integrated circuit device. The plurality of first pads 31 are used to be electrically coupled to input signals of the integrated circuit devices, the plurality of second pads 32 are used to be electrically coupled to output signals of the integrated circuit devices. The plurality of first pads 31 and the plurality of second pads 32 are located on a side of the plurality of the data transmission lines DATAL away from the display area 10. The plurality of first pads 31 and the plurality of second pads 32 extend in a direction of a boundary K of the display area 10. The plurality of second pads 32 are located between the plurality of first pads 31 and the plurality of data transmission lines DATAL, and are electrically coupled to the plurality of data transmission lines DATAL. When the integrated circuit device is installed in the integrated circuit device layout area 21, the plurality of first pads 31 and the plurality of second pads 32 may be electrically coupled (for example, via a manner such as welding, etc.) to corresponding input pins and output pins of the integrated circuit (IC) device. For example, the integrated circuit device may provide a signal on the data line DATA for each sub-pixel unit in the display area 10 when the display apparatus is operating, which means at least some pins of the integrated circuit device are electrically coupled to circuits of each sub-pixel unit, and thus in the manufacturing process of the display substrate, some test signals may be input from the pins to detect whether any manufacturing defect exists in a driving circuit of the sub-pixel unit or not. For testing the electrical properties after a module process (MDL), since the integrated circuit device is installed in the integrated circuit device layout area 21 at this time, the test signals may be input from corresponding pads of the plurality of first pads 31 to the integrated circuit device, and transferred to each sub-pixel unit in the display area 10 via the output terminal of the integrated circuit device, so as to realize testing of the electrical properties.

However, for the AT test described above, the situation is different. As mentioned earlier, the AT test is performed before manufacturing the light-emitting layer and installing the integrated circuit device. Therefore, when the AT test is performed, the integrated circuit device is not installed. Therefore, it is impossible to use the plurality of first pads 31 for the AT test.

For this, an array test assembly 40 is provided in the integrated circuit device layout area 21 on the display substrate according to the embodiments of the present disclosure. The array test assembly 40 is located between the plurality of first pads 31 and the plurality of second pads 32. After the integrated circuit device is installed, at least most part of the array test assembly 40 may be covered by the integrated circuit device, which means that the array test assembly 40 may not increase an additional wiring area of the display substrate. The layout of the array test assembly 40 makes full use of a gap between the first pad 31 and the second pad 32 in the integrated circuit device layout area 21, which is very helpful for reducing the wiring area. In addition, since the array test assembly 40 is only used for the AT test, it may not be covered by the integrated circuit device in subsequent processes and may not have any adverse effect on functions of the device.

In the embodiments according to the present disclosure, the array test assembly 40 includes a plurality of third pads 33 electrically coupled to the array test circuit and a plurality of connection terminals 41 electrically coupled to the plurality of second pads 32. The plurality of third pads 33 may be used to electrically couple with an external array test circuit 50. The array test circuit 50 is used to provide a test signal for the AT test, and the test signal may be, for example, a level signal to test whether the circuit has defects such as an open circuit or a short circuit or not, or may be other specific signals used to test the electrical properties of the TFT array. As an example, the array test assembly 40 may include a plurality of test channels, and each test channel is electrically coupled to one or some of the plurality of second pads 32 through one or more connection terminals 41 for the corresponding test. Each test channel obtains a test signal from its corresponding pad in the plurality of third pads 33 and transmits a corresponding test signal to a circuit to be tested via the corresponding connection terminal 41. An electrical coupling between the array test circuit 50 and at least some of the plurality of third pads 33 may be achieved in various ways, for example, by drawing probes from the array test circuit 50 and making the probes contact with the corresponding pads in the plurality of third pads 33, or by drawing input wires from the array test circuit 50 to fixedly connect the corresponding pads in the plurality of third pads 33, and the like. An electrical coupling between the array test circuit 50 and the corresponding pads in the plurality of third pads 33 does not mean that the array test circuit 50 is electrically coupled to all of the plurality of third pads 33 at the same time, for example, the array test circuit 50 may be electrically coupled to only a part of the plurality of third pads 33 (such as one or several pads) at the same time. The plurality of third pads 33 are located between the plurality of first pads 31 and the plurality of second pads 32, and at least part of the plurality of third pads 33 are electrically coupled to the corresponding pads in the plurality of second pads 32. Since at least some of the second pads 32 may be electrically coupled to the data lines DATA in the display area 10, therefore, at least some of the plurality of third pads 33 are electrically coupled to the corresponding second pads 32, which may be used to input test signals to the plurality of sub-pixel units PIX in the display area 10.

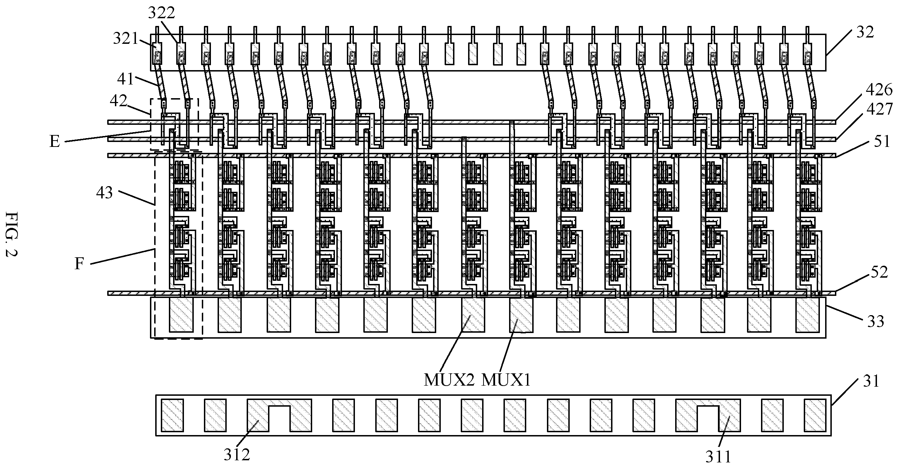

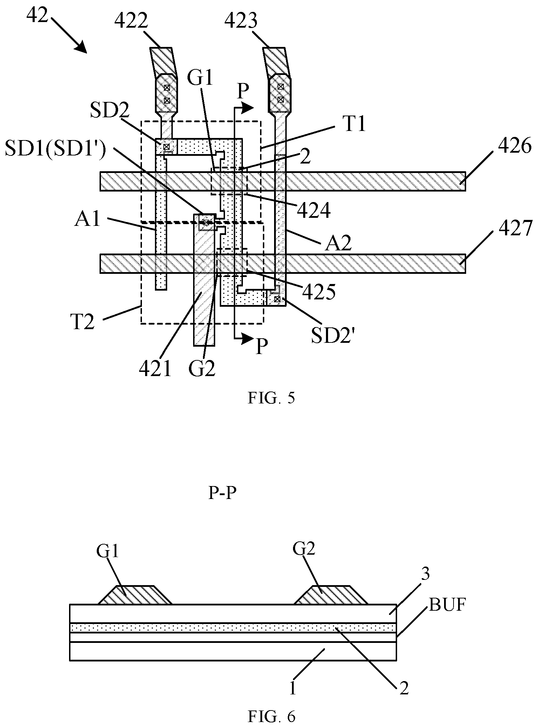

In embodiments of the claimed invention, in order to reduce a number of the plurality of third pads 33 and the wiring area in the array test assembly 40, a plurality of multiplexers 42 are provided in the array test assembly 40. The plurality of multiplexers 42 are located between the plurality of second pads 32 and the plurality of third pads 33, and at least one of the plurality of multiplexers 42 is electrically coupled to at least two second pads 32 in the plurality of second pads 32 and one third pad 33 in the plurality of third pads 33. As shown in FIGS. 2 and 5, the at least one multiplexer 42 may include: an input terminal 421, a first output terminal 422, a second output terminal 423, a first control switch 424, and a second control switch 425. The input terminal 421 is electrically coupled to one of the plurality of third pads 33, and the first output terminal 422 is electrically coupled to one pad (may be referred to as a first output pad 321) in the plurality of second pads 32, the second output terminal 423 is electrically coupled to another pad (may be referred to as a second output pad 322) in the plurality of second pads 32. The first control switch 424 is used to control the coupling and decoupling of the input terminal 421 and the first output terminal 422, and the second control switch 425 is used to control the coupling and decoupling of the input terminal 421 and the second output terminal 423. Generally, the multiplexer 42 may be in two states. In a first operating state, the first control switch 424 is turned on and the second control switch 425 is turned off, and a signal input from the input terminal 421 is only provided to the first output terminal 422; and in a second operating state, the first control switch 424 is turned off and the second control switch 425 is turned on, and a signal input from the input terminal 421 is only provided to the second output terminal 423. In this way, if it is possible to alternately control an on-off of the first control switch 424 and the second control switch 425, the multiplexer 42 may be controlled to switch back and forth between the first operating state and the second operating state, thereby it is possible to complete the test for two or more output channels through one input channel. This may reduce the wiring area, which is beneficial to narrow the frame of the display apparatus. It should be noted that the first operating state and second operating state described above are only exemplary. In the embodiments of the present disclosure, the multiplexer 42 may also in other states, for example, a third operating state of both of the first control switch 424 and the second control witch 425 are turned on, and a non-operating state of both of the first control switch 424 and the second control switch 425 are turned off.

In order to control the operations of the first control switch 424 and the second control switch 425, the array test assembly 40 may further include a first control line 426 and a second control line 427. The first control line 426 is electrically coupled to a control terminal of the first control switch 424 of each multiplexer 42, and the second control line 427 is electrically coupled to a control terminal of the second control switch 425 of each multiplexer 42. Signals on the first control line 426 and the second control line 427 may be input from outside, for example, from the plurality of third pads 33. The plurality of third pads 33 include: a first control terminal pad MUX1 and a second control terminal pad MUX2. The first control terminal pad MUX1 is electrically coupled to the first control line 426, and the second control terminal pad MUX2 is electrically coupled to the second control line 427. As an example, control signals input from the first control terminal pad MUX1 and the second control terminal pad MUX2 to the first control line 426 and the second control line 427 may be periodic pulse signals or clock signals, and the like.

In some embodiments, the control switch described above may be realized by a thin film transistor structure. For example, as shown in FIG. 2 and FIG. 5, the first control switch 424 may include a first thin film transistor T1, the control terminal of the first control switch 424 is a gate G1 of the first thin film transistor T1, one SD1 (for example, a source) of the source and the drain of the first thin film transistor T1 is electrically coupled to the input terminal 421 of the multiplexer 42, another SD2 (for example, the drain) of the source and the drain of the first thin film transistor T1 is electrically coupled to the first output terminal 422 of the multiplexer 42. The second control switch 425 includes a second thin film transistor T2, the control terminal of the second control switch 425 is a gate G2 of the second thin film transistor T2, one SD1' (for example, a source) of the source and the drain of the second thin film transistor T2 is also electrically coupled to the input terminal 421 of the multiplexer 42, another SD2' (for example, the drain) of the source and the drain of the second thin film transistor T2 is electrically coupled to the second output terminal 423 of the multiplexer 42. In some embodiments, one SD1 of the source and the drain of the first thin film transistor T1 and one SD1' of the source and the drain of the second thin film transistor T2 are electrically coupled to a same pad in the plurality of third pads 33, another one SD2 of the source and the drain of the first thin film transistor T1 is electrically coupled to one of the plurality of second pads 32, and another SD2' of the source and the drain of the second thin film transistor T2 is electrically coupled to another of the plurality of second pads. The gate G1 of the first thin film transistor T1 is electrically coupled to the first control line 426, and the gate G2 of the second thin film transistor T2 is electrically coupled to the second control line 427.

FIG. 6 shows a cross-sectional view taken along a line P-P in the above mentioned double-transistor (the first thin film transistor T1 and the second thin film transistor T2) structural view. FIG. 6 shows a base substrate 1, an active layer 2 on the base substrate 1, a gate insulating layer 3 on a side of the active layer 2 away from the base substrate 1, and a gate G1 and a gate G2 on a side of the gate insulating layer 3 away from the active layer 2. As an example, a buffer layer BUF may also be provided between the active layer 2 and the base substrate 1. In the example shown in FIG. 5, portions of the active layer 2 only overlapping the first control line 426 and the second control line 427 are used as channel areas of the first thin film transistor T1 and the second thin film transistor T2, respectively, and other portions of the active layer 2 are used as conductors for electrical coupling. To make structures of the first thin film transistor T1 and the second thin film transistor T2 in the multiplexer 42 more balanced, the first thin film transistor T1 may include a first extension A1, and the second thin film transistor T2 may include a second extension A2. The first extension A1 and the second extension A2 may be arranged in a same layer, for example, in the active layer 2. The first extension A1 is coupled to another SD2 of the source and the drain of the first thin film transistor T1 electrically coupled to the first input terminal 422 of the multiplexer 42, and the second extension A2 is coupled to another SD2' of the source and the drain of the second thin film transistor T2 electrically coupled to the second input terminal 423 of the multiplexer 42. Orthographic projections of the first extension A1 and the second extension A2 on the base substrate 1 overlap an orthographic projection of the first control line 426 on the base substrate 1, and the orthographic projections of the first extension A1 and the second extension A2 on the base substrate 1 overlap an orthographic projection of the second control line 427 on the base substrate 1. An overlapping area of the first extension A1 with the first control line 426 and the second control line 427 is substantially same as an overlapping area of the second extension A2 with the first control line 426 and the second control line 427. This may make parasitic capacitances in the first thin film transistor T1 and the second thin film transistor T2 more consistent, thereby making the test signals output by the two output terminals of the multiplexer 42 more uniform and stable.

Although the multiplexer with two output channels has been described above as an example, it should be understood that the embodiments of the present disclosure are not limited to this, for example, according to actual requirements, a single multiplexer 42 may have more output channels, for example, one input signal may be multiplexed to four, eight or even more output signals to further reduce an area occupied by the array test assembly 40.

As stated above, the array test assembly 40 is only used at a stage of AT testing, and is not effective in subsequent manufacturing stages and a using stage of final products. Therefore, it is hoped that the array test assembly 40 affects the subsequent manufacturing test of the display apparatus and the normal use of the final products as less as possible. Therefore, the plurality of multiplexers 41 described above may be configured to be turned off at the display stage of the display substrate. The plurality of multiplexers 41 described above may also be configured to be turned off at the subsequent manufacturing test stage (for example, a test after light-emitting materials are evaporated, a test after the integrated circuit device is installed, etc.) of the display apparatus. In this way, the plurality of third pads 33 and the data lines DATA may be decoupled at the display stage and at the subsequent manufacturing test stage of the display substrate, so as to prevent an assembly used for the AT test interfering display operations and the subsequent tests of the display substrate. In some embodiments, a first level signal may be access on the first control line 426 and a second level signal may be access on the second control line 427 to make a gate G1 of the first thin film transistor T1 and a gate G2 of the second thin film transistor T2 in the multiplexer 42 turn off during the display stage of the display substrate.

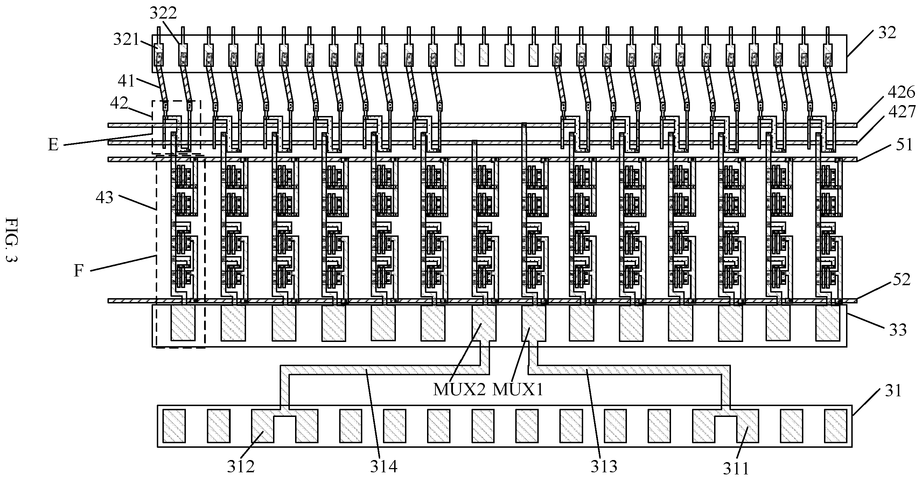

In some embodiments, as shown in FIG. 3, the plurality of first pads 31 described above may include: a first level input pad 311 and a second level input pad 312. A number of the first level input pad 311 and the second level input pad 312 may be one or more. The first level input pad 311 is electrically coupled to the first control terminal pad MUX1 through a first level signal line 313 for accessing the first level signal, and the first level signal keeps the first control switch 424 in the multiplexer 42 off. The second level input pad 312 is electrically coupled to the second control terminal pad MUX2 through a second level signal line 314 for accessing the second level signal, and the second level signal keeps the second control switch 425 in the multiplexer 42 off. As an example, both of the first level signal and the second level signal may be high-level signals (VGH) (for example, positive voltage signals with voltages between 6V and 8V). In an example shown in FIG. 3, two adjacent first level input pads 311 are electrically coupled to each other, and two adjacent second level input pads 312 are also electrically coupled to each other. This facilitates increasing a stability of signals. However, the embodiments of the present disclosure are not limited to this, for example, the first level input pad 311 and the second level input pad 312 may constitute a separate pad, or a plurality of first level input pads 311 electrically coupled to each other and a plurality of second level input pads 312 electrically coupled to each other. Here, the first control terminal pad MUX1 and the second control terminal pad MUX2 only show a sequence, and the first control terminal pad MUX1 and the second control terminal pad MUX2 are interchangeable.

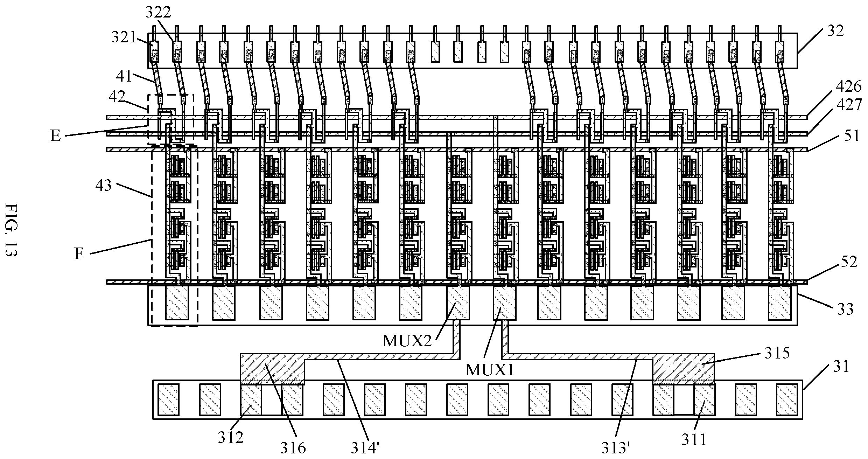

In some embodiments, as shown in FIG. 13, the display substrate may further include a first level connection portion 315 and a second level connection portion 316, and the number of the first level input pads 311 may be set to multiple, and the number of the second level input pads 312 may also be set to multiple. The first level connection portion 315 is located between the plurality of first level input pads 311 and the first level signal line 313', and is electrically coupled to the first level signal line 313' and the plurality of first level input pads 311; the second level connection portion 316 is located between the plurality of second level input pads 312 and the second level signal line 314', and is electrically coupled to the second level signal line 314' and the plurality of second level input pads 312. As an example, the first level connection portion 315 and the second level connection portion 316 may be arranged on a same layer with the first level signal line 313' and the second level signal line 314', and are arranged on different layers with the first level input pads 311 and the second level input pads 312. For example, the first level connection portion 315 may be electrically coupled to the plurality of first level input pads 311 through a via hole structure, and the second level connection portion 316 may be electrically coupled to the plurality of second level input pads 312 through a via hole structure.

In some embodiments, the first level connection portion 315 and the first level signal line 313' may be an integrated structure, and the second level connection portion 316 and the second level signal line 314' may be an integrated structure.

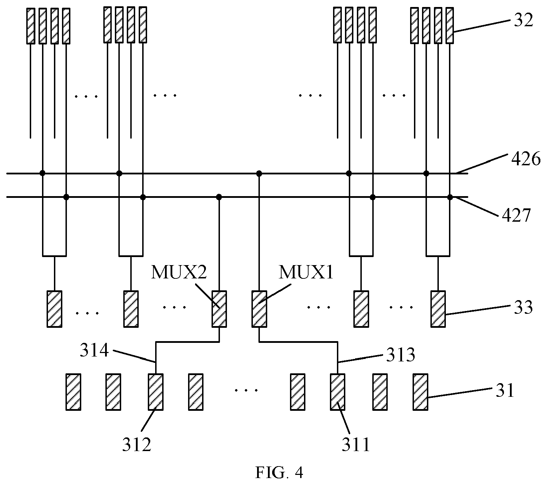

The coupling mode described above keep the first control switch 424 and the second control switch 425 in the multiplexer 42 off when the integrated circuit device has an input signal (which may be a test signal or a normal operating signal). It may be seen from FIG. 3 and FIG. 4, the output terminal of the multiplexer 42 is coupled to the output terminal of the integrated circuit device, and thus, if the first control switch 424 and the second control switch 425 in the multiplexer 42 may not be kept off, a leakage current may occur, which may interfere the output signal (which may be a driving signal of a data line in an normal operation, and may be other test signals in the subsequent test stages) of the integrated circuit device. Therefore, the coupling mode described above may avoid interferences from the array test assembly 40 to the tests in the subsequent manufacturing stages or the operating signals of the finished products of the display apparatus. In the above example, both the first level signal and the second level signal may be high-level signals (VGH). However, it should be understood that designs of the first control switch 424 and the second control switch 425 in the multiplexer 42 may be various. For example, transistors may be divided into N-type transistors and P-type transistors according to the characteristics thereof. When the transistor is a P-type transistor, a turn-on voltage is a low-level voltage (for example, 0V, -5V, -10V or other suitable voltages), and a turn-off voltage is a high-level voltage (for example, 5V, 10V or other suitable voltages). When the transistor is an N-type transistor, a turn-on voltage is a high-level voltage (for example, 5V, 10V or other suitable voltage), and a turn-off voltage is a low-level voltage (for example, 0V, -5V, - 10V or other suitable voltages). Therefore, if at least one of the first control switch 424 and the second control switch 425 adopts the N-type transistor, it may be designed to be turned off under control of a high-level signal (VGH), as described above, in this case, the corresponding first level signal and second level signal may be high-level signals (VGH). If at least one of the first control switch 424 and the second control switch 425 adopts the P-type transistor, it may be designed to be turned off under control of a low-level signal (VGL), in this case, at least one of the first level signal and second level signal may be a low-level signal (VGL) (for example, a negative voltage signal with a voltage, for example, between -8V and -6V).

In some embodiments, the first control line 426, the second control line 427, the first level signal line 313, the second level signal line 314, the gate G1 of the first thin film transistor T1, and the gate G2 of the second thin film transistor T2 are made of a same material and are arranged on a same layer. This may simplify the process and save cost.

In some embodiments, the array test assembly 40 may further include: a high-level signal (VGH) line 51 (for example, used to provide a positive level signal (for example, with a voltage between 6V and 8V), which may also be referred to as a third-level signal line); a low-level signal (VGL) line (for example, used to provide a negative level signal (for example, with a voltage between -8V and -6V), which may also be referred to as a fourth-level signal line) 52; and a plurality of electrostatic discharge structures 43. The electrostatic discharge structure 43 is used to discharge static electricity in time to prevent an accumulation of the static electricity from damaging the array test assembly 40.

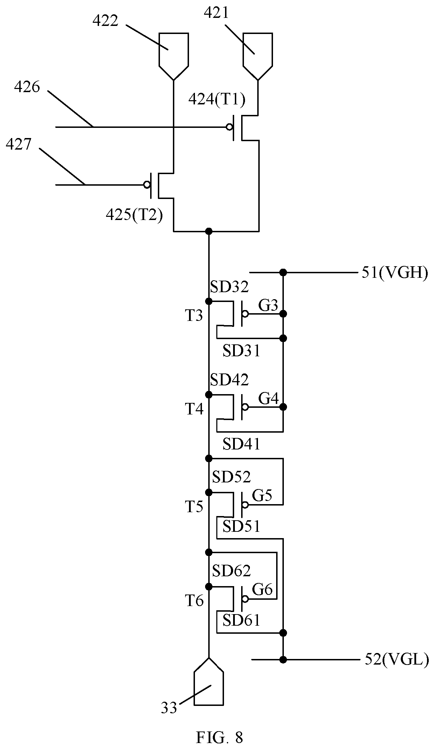

FIG. 8 shows a schematic diagram of a circuit structure corresponding to a single input channel in the array test assembly 40. The figure shows the multiplexer 42 and the electrostatic discharge structure 43. At least one electrostatic discharge structure 43 includes: a third thin film transistor T3, a fourth thin film transistor T4, a fifth thin film transistor T5, and a sixth thin film transistor T6. A gate G3 of the third thin film transistor T3 is electrically coupled to the high-level signal line 51, one SD31 of the source and drain of the third thin film transistor T3 is electrically coupled to the high-level signal line 51, another SD32 of the source and drain of the third thin film transistor T3 is electrically coupled to the corresponding input terminal of the array test assembly 40 (the corresponding pad in the plurality of third pads 33). A gate G4 of the fourth thin film transistor T4 is electrically coupled to the high-level signal line 51, one SD41 of the source and drain of the fourth film transistor T4 is electrically coupled to the high-level signal line 51, another SD42 of the source and drain of the fourth thin film transistor T4 is electrically coupled to the corresponding input terminal of the array test assembly 40 (the corresponding pad in the plurality of third pads 33). The fourth thin film transistor T4 and the third thin film transistor T3 may be coupled in parallel. A gate G5 of the fifth thin film transistor T5 is electrically coupled to the corresponding input terminal of the array test assembly 40 (the corresponding pad in the plurality of third pads 33), one SD51 of the source and drain of the fifth film transistor T5 is electrically coupled to the low-level signal line 52, another SD52 of the source and drain of the fifth thin film transistor T5 is electrically coupled to the corresponding input terminal of the array test assembly 40 (the corresponding pad in the plurality of third pads 33). A gate G6 of the fifth thin film transistor T6 is electrically coupled to the corresponding pad in the plurality of third pads 33, one SD61 of the source and drain of the sixth film transistor T6 is electrically coupled to the low-level signal line 52, and another SD62 of the source and drain of the sixth thin film transistor T6 is electrically coupled to the corresponding pad in the plurality of third pads 33.

It may be seen from FIG. 8 that a test signal line Signal is used to electrically couple the corresponding input terminal of the array test assembly 40 (that is, the corresponding pad in the plurality of third pads 33) to the input terminal 421 of the multiplexer 42. Since an electrostatic voltage on the test signal line Signal may be either a positive voltage or a negative voltage, in the embodiments of the present disclosure, two ways of discharging static electricity are provided for the test signal line Signal, that is, discharging static electricity to the high-level signal line 51 through the third thin film transistor T3 and the fourth thin film transistor T4, and discharging static electricity to the low-level signal line 52 through the fifth thin film transistor T5 and the sixth thin film transistor T6. When a voltage difference between a node on the test signal line Signal and the high-level signal line 51 is greater than a threshold voltage of the third thin film transistor T3 and the fourth thin film transistor T4, the third thin film transistor T3 and the fourth thin film transistor T4 may be turned on, so that the electrostatic voltage on the test signal line Signal is discharged to the high-level signal line 51. When a voltage difference between a node on the test signal line Signal and the low-level signal line 52 is greater than a threshold voltage of the fifth thin film transistor T5 and the sixth thin film transistor T6, the fifth thin film transistor T5 and the sixth thin film transistor T6 may be turned on, so that the electrostatic voltage on the test signal line Signal is discharged to the low-level signal line 52. The fourth thin film transistor T4 is located on a side of the third thin film transistor T3 away from the display area 10. The sixth thin film transistor T6 is located on a side of the fifth thin film transistor T5 away from the display area 10. The parallel structure of the fourth thin film transistor T4 and the third thin film T3 and the parallel structure of the sixth thin film transistor T6 and the fifth thin film transistor T5 are beneficial for increasing a discharge capability of the electrostatic discharge structure 43.

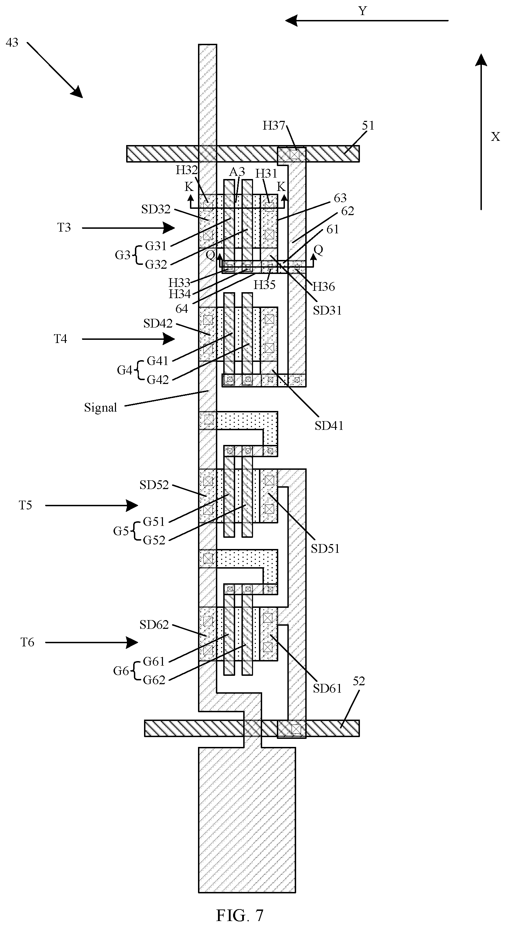

In the following, the thin film transistor T3 is taken as an example to briefly describe the structure of the thin film transistor described above. As shown in FIG. 7, the third thin film transistor T3 includes an active layer A3, and an orthographic projection of the active layer A3 on the base substrate 1 may, for example, have a rectangular shape. As shown in FIGS. 7 and 10, one terminal of the active layer A3 is coupled to (for example, L-shaped) one SD31 of the source and drain of the third thin film transistor T3 through a via hole H31, another terminal of the active layer A3 is coupled to (for example, bar-shaped) another SD32 of the source and drain of the third thin film transistor T3 through a via hole H32. It may be seen from FIG. 10 that a gate insulating layer GI is provided on a side of the active layer A3 away from the base substrate 1, a gate G3 is provided on a side of the gate insulating layer GI away from the base substrate 1 (the gate G3 includes, for example, a first bar-like sub-gate G31 and a second bar-like sub-gate G32 arranged side by side), and an interlayer dielectric layer IDL is provided on a side of the gate G3 away from the base substrate 1. As an example, a second gate insulating layer GI2 may also be provided between the interlayer dielectric layer IDL and the gate G3. The one SD31 of the source and drain of the third thin film transistor T3 and the another SD32 of the source and drain of the third thin film transistor T3 are provided on a side of the interlayer dielectric layer IDL away from the base substrate 1. As an example, a buffer layer BUF may also be provided between the base substrate 1 and the active layer A3. FIG. 9 shows a cross-sectional view taken along line Q-Q in FIG. 7. FIG. 9 shows that the another SD32 of the source and drain of the third thin film transistor T3 is coupled to the first bar-like sub-gate G31 through a via hole H33, and is coupled to the second bar-like sub-gate G32 through a via hole H34, and is coupled to a first connection portion 61 through a via hole H35. The first connection portion 61 is further electrically coupled to a second connection portion 62 through a via hole H36, and the second connection portion 62 is further electrically coupled to the high-level signal line 51 through a via hole H37. Another SD32 of the source and drain of the third thin film transistor T3 may be, for example, formed by a part of the test signal line Signal. The one SD31 of the source and drain of the third thin film transistor T3 and the another SD32 of the source and drain of the third thin film transistor T3, the test signal line Signal, and the second connection portion 62 are made of a same material and are arranged on a same layer, and the first connection portion 61 and the active layer A3 are made of a same material and are arranged on a same layer, the first bar-like sub-gate G31 and the second bar-like sub-gate G32 and the high-level signal line 51 are made of a same material and are arranged on a same layer. The provision of the first connection portion 61 may increase resistances between the one SD31 (for example, the drain) of the source and drain of the third thin film transistor T3 and the high-level signal line 51, which is beneficial for preventing the third thin film transistor T3 from being damaged due to excessive discharge current. It may be seen from FIG. 7 that, the one SD31 of the source and drain of the third thin film transistor T3 has a first arm portion 63 and a second arm portion 64, the first arm portion 63 extends in a first direction (for example, x direction in the drawing), the second arm portion 64 extends in a second direction (for example, y direction in the drawing) crossing (for example, perpendicular to) the first direction (for example, x direction in the drawing). The first arm portion 63 is coupled to the active layer A3 through the via hole H31. The second arm portion 64 is coupled to the first bar-like sub-gate G31 through the via hole H33 and is coupled to the second bar-like sub-gate G32 through the via hole H34. As an example, similar to FIG. 9, a buffer layer BUF may also be provided between the base substrate 1 and the first connection portion 61. The interlayer dielectric layer IDL may be provided on a side of the gate G3 away from the base substrate 1. As an example, a second gate insulating layer GI2 may also be provided between the interlayer dielectric layer IDL and the gate G3.

Structures of other thin film transistors in the electrostatic discharge structure 43 are similar to that of the third thin film transistor T3, and may not be described one by one here. In some embodiments, gates of one, two, three, or four of the third thin film transistor T3, the fourth thin film transistor T4, the fifth thin film transistor T5, and the sixth thin film transistor T6 include a first bar-like sub-gate and a second bar-like sub-gate which are arranged side by side, one end of the first bar-like sub-gate is electrically coupled to one end of the second bar-like sub-gate (which may be directly coupled or coupled through structures such as via holes). This dual-sub-gate design may better improve a driving capability of the transistor.

In some embodiments, at least some of the plurality of second pads 32 are electrically coupled to the plurality of data lines DATA in the display area 10 (for example, with reference to FIG. 1), respectively. This is beneficial for testing the electrical properties of circuit units in the display area 10.

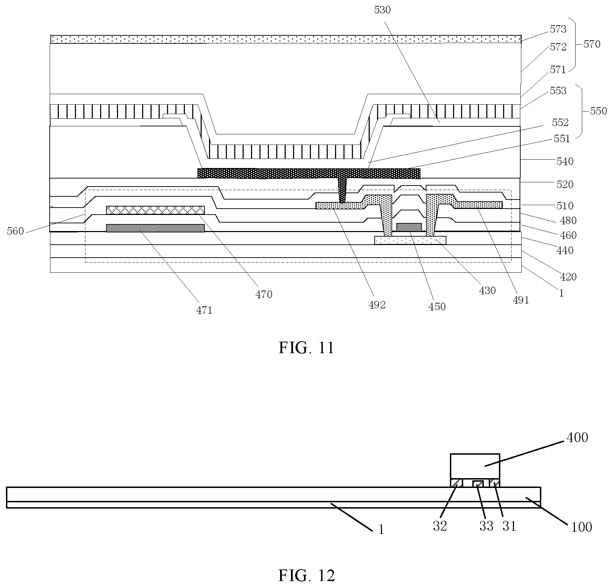

FIG. 11 schematically shows a film structure of the sub-pixel unit in the display area 10. As shown in FIG. 11, in some embodiments, at least one of the plurality of sub-pixels includes a pixel circuit 560 and a light-emitting element 550, and the pixel circuit 560 is located between the base substrate 1 and the light-emitting element 550. Limited by the drawing frame, only part of the pixel circuit 560 may be shown, which is shown in a dashed frame in FIG. 11.

The light-emitting element 550 includes a first electrode 553 (for example, a cathode), a light-emitting layer 552, and a second electrode 551 (for example, an anode) stacked in sequence, and the second electrode 551 is located on a side of the light-emitting layer facing the base substrate. The pixel circuit 560 includes at least one thin film transistor, the thin film transistor includes a gate 450 on the base substrate 1, a source 491 and a drain 492 on a side of the gate 450 away from the base substrate 1, and the source 491 or the drain 492 of the thin film transistor is electrically coupled to the second electrode 551. The source 491 and the drain 492 of the at least one thin film transistor are arranged on a same layer (a layer may be referred to as the source and drain layer) with the plurality of first pads 31, the plurality of second pads 32, and the plurality of third pads 33, and they may be formed by a same patterning process.

In some embodiments, the first level connection portion 315, the first level signal line 313', the second level connection portion 316, the second level signal line 314', and the gate 450 of the thin film transistor in the pixel circuit 560 are located on a same layer and may be formed by a same process.

In some embodiments, film structures of the sub-pixel unit may further include a buffer layer 420, an active layer 430, a first gate insulating layer 440, a second gate insulating layer 460, a second gate layer (a layer of the gate 450 described above may be referred to as a first gate layer), an interlayer dielectric layer 480, a passivation layer 510, a planarization layer 520, a pixel defining layer 540, and an encapsulation layer 570 on the base substrate 1 in sequence.

Specifically, the base substrate 1 is, for example, a flexible PI (polyimide) substrate made of transparent materials; the buffer layer 420 is made of transparent insulating materials such as silicon oxide, silicon nitride, etc.; the active layer 430 includes an active area of the thin film transistor in the pixel circuit, and may be made of semiconductor materials; the first gate insulating layer 440 may be made of transparent insulating materials such as silicon oxide, silicon nitride, etc.; the first gate layer may be made of metal materials, the gate 450 of the thin film transistor and a first electrode 471 of a storage electrode may be formed in the first gate layer; the second gate insulating layer 460 may be made of transparent insulating materials such as silicon oxide, silicon nitride, etc.; the second gate layer may be used to, for example, form a second electrode 470 of the storage electrode. The interlayer dielectric layer 80 is made of transparent insulating materials such as silicon oxide, silicon nitride, etc.; the source and drain layer is, for example, made of metal materials; the passivation layer 510 is made of transparent insulating materials such as silicon oxide, silicon nitride, etc.; the planarization layer 520 is made of transparent organic materials such as silicon oxide, silicon nitride, etc.; the pixel defining layer 540 is supported by transparent organic materials to define a light-emitting area in the sub-pixel unit, and may be formed by a patterning process. The encapsulation layer 570 includes a first inorganic encapsulation layer 571, an organic encapsulation layer 572, and a second inorganic encapsulation layer 573 away from the base substrate 1 in sequence, the first inorganic encapsulation layer 571, the organic encapsulation layer 572, and the second inorganic encapsulation layer 573 are stacked, and the encapsulation layer 170 is light-transparent.

Those skilled in the art should understand that, the structure shown in FIG. 11 is merely illustrative, which mainly shows the layer structure constituting the sub-pixel unit in the display area 10 of the OLED display substrate, and shows transmitting the signal of the pixel circuit to the light-emitting element through the thin film transistor to realize the light-emitting.

In some embodiments, as shown in FIG. 1, the display substrate may be a bendable substrate, the display substrate includes a foldable area 30, and the plurality of second pads 32 are far away from the display area 10 than the bendable area 30. Correspondingly, the plurality of first pads 31 and the plurality of third pads 33 are also far away from the display area 10 than the bendable area 30. In this way, by folding the bendable area 30, the integrated circuit device layout area 40 including the plurality of first pads 31, the plurality of second pads 32, and the plurality of third pads 33 may be folded to a back side of the display screen, thereby reducing a frame width of the display apparatus.

In some embodiments, in a case that the integrated circuit device is installed in the integrated circuit device layout area 21, an orthographic projection of the integrated circuit device on the base substrate 1 at least partially overlaps an orthographic projection of the array test assembly 40 on the base substrate 1, which leads to the array test assembly 40 in the finished product to be totally covered by the integrated circuit device, and may not occupy excessive space. As an example, the orthographic projection of the integrated circuit device on the base substrate 1 may be consistent with the orthographic projection of the integrated circuit device layout area 21 on the base substrate 1.

In the embodiments of the present disclosure, the array test assembly 40 is a general term of a structure used for the AT test between the plurality of first pads 31 and the plurality of second pads 32. As stated above, the array test assembly 40 may include, for example, at least some of the plurality of third pads 33, the plurality of multiplexers 42, the high-level signal line 51, the low-level signal line 52, the plurality of electrostatic discharge structures 43, the first level signal line 313, and the second level signal line 314, and the like.

In the embodiments of the present disclosure, a source of the thin film transistor and a drain of the thin film transistor may be used interchangeably. Therefore, in the above expression, expressions "one of the source and the drain" and "another of the source and the drain" are used to express one or another of the source and the drain, rather than distinguishing the source and the drain specifically.

The embodiments of the present disclosure further provide a display apparatus. As shown in FIG. 12, the display apparatus may include the display substrate 100 and the integrated circuit device 400 according to any embodiment stated above, the integrated circuit device 400 is bound with the plurality of first pads 31 and the plurality of second pads 32.

In some embodiments, the orthographic projection of the integrated circuit device 400 on the base substrate 1 at least partially overlaps the orthographic projection of the plurality of third pads 33 on the base substrate 1, for example, totally overlaps the orthographic projection of the plurality of third pads 33 on the base substrate 1. This facilitates saving the wiring area of the display substrate.

In some embodiments, the plurality of multiplexers 42 may be configured to be turned off when the display apparatus is operating.

As an example, the display apparatus may be any product or component with a display function such as televisions, displays, digital frames, mobile phones, smart watches, tablet computers, etc..

The above description is only explanation to the exemplary embodiments of the present disclosure and the applied technical principles. Those skilled in the art should understand that the scope of the invention involved in the present disclosure is not limited to the technical solutions formed by the specific combination of the above technical features, and should also cover other technical solutions formed by any combination of the technical solutions described above and its equivalent features without departing from the scope of protection defined by the appended claims.

## Claims

1. A display substrate (100), comprising:
a base substrate (1) comprising a display area (10) and a peripheral area (20) surrounding the display area (10);
a plurality of sub-pixel units (PIX) in the display area (10);
a plurality of data lines (DATA) in the display area (10) and electrically coupled to the plurality of sub-pixel units (PIX), respectively;
a plurality of data transmission lines (DATAL) in the peripheral area (20) on at least one side of the display area (10) and electrically coupled to the plurality of data lines (DATA), respectively;
a plurality of first pads (31) and a plurality of second pads (32) on a side of the plurality of data transmission lines (DATAL) away from the display area (10), wherein the plurality of first pads (31) and the plurality of second pads (32) extend in a direction of a boundary of the display area (10), respectively, and the plurality of second pads (32) are located between the plurality of first pads (31) and the plurality of data transmission lines (DATAL) and are electrically coupled to the plurality of data transmission lines (DATAL), wherein the plurality of first pads (31) are configured to be electrically coupled to input signals of an integrated circuit device, the plurality of second pads (32) are configured to be electrically coupled to output signals of the integrated circuit device;
a plurality of third pads (33) between the plurality of first pads (31) and the plurality of second pads (32), wherein at least part of the plurality of third pads (33) are electrically coupled to the plurality of second pads (32), and the plurality of third pads (33) further comprise a first control terminal pad (MUX1) and a second control terminal pad (MUX2); and
a plurality of multiplexers (42) between the plurality of second pads (32) and the plurality of third pads (33), wherein at least one of the plurality of multiplexers (42) is electrically coupled to at least two of the plurality of second pads (32) and one of the plurality of third pads (33), and at least one of the plurality of multiplexers (42) comprises a first thin film transistor (T1) and a second thin film transistor (T2),
wherein the display substrate (100) further comprises a first level signal line (313) and a second level signal line (314) between the plurality of first pads (31) and the plurality of third pads (33),
wherein the plurality of first pads (31) comprise at least one first level input pad (311) and at least one second level input pad (312), and
wherein the at least one first level input pad (311) is electrically coupled to the first control terminal pad (MUX1) through the first level signal line (313) and is configured to receive a first level signal which keeps the first thin film transistor (T1) in the multiplexer (42) off, and the at least one second level input pad (312) is electrically coupled to the second control terminal pad (MUX2) through the second level signal line (314) and is configured to receive a second level signal which keeps the second thin film transistor (T2) in the multiplexer (42) off,
wherein the first thin film transistor (T1) comprises a first source, a first drain, and a first gate, the second thin film transistor (T2) comprises a second source, a second drain, and a second gate; and
wherein one of the first source and the first drain and one of the second source and the second drain are electrically coupled to a same pad in the plurality of third pads (33), the other of the first source and the first drain is electrically coupled to one of the plurality of second pads (32), the other of the second source and the second drain is electrically coupled to another pad of the plurality of second pads (32); and
wherein the first gate is electrically coupled to a first control line (426), the second gate is electrically coupled to a second control line (427), the first control line (426) is configured to receive the first level signal, the second control line (427) is configured to receive the second level signal, and the first level signal and the second level signal are configured to turn off the first gate and the second gate in the multiplexer (42),
wherein
the first control terminal pad (MUX1) is electrically coupled to the first control line (426); and
the second control terminal pad (MUX2) is electrically coupled to the second control line (427).

2. The display substrate (100) according to claim 1, further comprising: a first level connection portion (315) and a second level connection portion (316), wherein a number of the at least one first level input pad (311) is multiple, and a number of the at least one second level input pad (312) is multiple; and
wherein the first level connection portion (315) is between the plurality of first level input pads (311) and the first level signal line (313'), and is electrically coupled to the first level signal line (313') and the plurality of first level input pads (311); and the second level connection portion (316) is between the plurality of second level input pads (312) and the second level signal line (314'), and is electrically coupled to the second level signal line (314') and the plurality of second level input pads (312).

3. The display substrate (100) according to claim 2, wherein the first level connection portion (315) and the first level signal line (313') are in an integrated structure, and the second level connection portion (316) and the second level signal line (314') are in an integrated structure.

4. The display substrate (100) according to claim 3, wherein the first control line (426), the second control line (427), the first level signal line (313'), the second level signal line (314'), the gate of the first thin film transistor (T1), and the gate of the second thin film transistor (T2) are made of a same material and are arranged on a same layer.

5. The display substrate (100) according to any of claims 1 to 4, wherein the plurality of third pads (33) are configured to input test signals to the plurality of sub-pixels, and the plurality of first pads (31) and the plurality of second pads (32) are configured to be bound with the same integrated circuit device.

6. The display substrate (100) according to any of claims 1 to 5, further comprising: a third level signal line and a fourth level signal line; and a plurality of electrostatic discharge structures (43), wherein the third level signal line is configured to provide a positive level signal, and the fourth level signal line is configured to provide a negative level signal, and
wherein at least one of the electrostatic discharge structures (43) comprises:
a third thin film transistor (T3), wherein a gate of the third thin film transistor (T3) is electrically coupled to the third level signal line, one of a source and a drain of the third thin film transistor (T3) is electrically coupled to the third level signal line, and the other of the source and the drain of the third thin film transistor is electrically coupled to a corresponding pad in the plurality of third pads (33);
a fourth thin film transistor (T4), wherein a gate of the fourth thin film transistor (T4) is electrically coupled to the third level signal line, one of a source and a drain of the fourth thin film transistor (T4) is electrically coupled to the third level signal line, and the other of the source and the drain of the fourth thin film transistor (T4) is electrically coupled to a corresponding pad in the plurality of third pads (33);
a fifth thin film transistor (T5), wherein a gate of the fifth thin film transistor (T5) is electrically coupled to a corresponded pad in the plurality of third pads (33), one of a source and a drain of the fifth thin film transistor (T5) is electrically coupled to the fourth level signal line, and the other of the source and the drain of the fifth thin film transistor (T5) is electrically coupled to a corresponding pad in the plurality of third pads (33); and
a sixth thin film transistor (T6), wherein a gate of the sixth thin film transistor (T6) is electrically coupled to a corresponding pad in the plurality of third pads (33), one of a source and a drain of the sixth thin film transistor (T6) is electrically coupled to the fourth level signal line, and the other of the source and the drain of the sixth thin film transistor (T6) is electrically coupled to a corresponding pad in the plurality of third pads (33).

7. The display substrate (100) according to claim 6, wherein both the third thin film transistor (T3) and the fourth thin film transistor (T4) comprise an active layer; and
wherein the gate of the third thin film transistor (T3) and the gate of the fourth thin film transistor (T4) comprise a first bar-like sub-gate and a second bar-like sub-gate; and
wherein one of the source and the drain of each of the third thin film transistor (T3) and the fourth thin film transistor (T4) has a first arm portion (63) and a second arm portion (64) coupled to each other, the first arm portion (63) extends in a first direction, and the second arm portion (64) extends in a second direction crossing the first direction, the first arm portion (63) is coupled to the active layer through a first via hole, and the second arm portion (64) is coupled to the first bar-like sub-gate through a second via hole structure and is coupled to the second bar-like sub-gate through a third via hole; and
wherein the electrostatic discharge structure (43) further comprises: a first connection portion (61) and a second connection portion (62); and
wherein the first connection portion (61) and the active layer are made of a same material and are arranged on a same layer, and the second connection portion (62) and the source and the drain are made of a same material and are arranged on a same layer; and
wherein the first connection portion (61) is coupled to one of the source and the drain of each of the third thin film transistor (T3) and the fourth thin film transistor (T4) through the third via hole structure, the first connection portion (61) is coupled to the second connection portion (62) through a fourth via hole, and the second connection portion (62) is coupled to the third level signal line through a fifth via hole structure.

8. The display substrate (100) according to any of claims 2 to 4, wherein at least one of the plurality of sub-pixel units (PIX) comprises a pixel circuit (560) and a light-emitting element (550), the pixel circuit (560) is between the base substrate (1) and the light-emitting element (550); and
wherein the light-emitting element (550) comprises a first electrode (553), a light-emitting layer (552), and a second electrode (551) stacked in sequence, and the second electrode (551) is located on a side of the light-emitting layer facing the base substrate (1); and
wherein the pixel circuit (560) comprises at least one thin film transistor, the thin film transistor comprises a gate on the base substrate (1), a source and a drain on a side of the gate away from the base substrate (1), and the source or the drain of the thin film transistor is electrically coupled to the second electrode (551); and
the source and the drain of the at least one thin film transistor are arranged on a same layer with the plurality of first pads (31), the plurality of second pads (32), and the plurality of third pads (33); and
wherein the first level connection portion (315), the first level signal line (313'), the second level connection portion (316), the second level signal line (314'), and the gate of the thin film transistor in the pixel circuit (560) are located on a same layer.

9. The display substrate (100) according to any of claims 1 to 8, wherein the display substrate (100) is a bendable substrate, the display substrate (100) comprises a bendable area (30), and the plurality of second pads (32) are far away from the display area (10) than the bendable area (30).

10. A display apparatus, comprising:
the display substrate (100) according to any of claims 1 to 9; and
an integrated circuit device (400), wherein the integrated circuit device (400) is bound with the plurality of first pads (31) and the plurality of second pads (32).

11. The display apparatus according to claim 10, wherein an orthographic projection of the integrated circuit device (400) on the base substrate (1) at least partially overlaps orthographic projections of the plurality of third pads (33) on the base substrate (1).

## Patentansprüche

1. Anzeigesubstrat (100), umfassend:
ein Basissubstrat (1), umfassend einen Anzeigebereich (10) und einen Randbereich (20), der den Anzeigebereich (10) umgibt;
eine Vielzahl von Subpixeleinheiten (PIX) in dem Anzeigebereich (10);
eine Vielzahl von Datenleitungen (DATA) in dem Anzeigebereich (10) und jeweils elektrisch gekoppelt an die Vielzahl von Subpixeleinheiten (PIX);
eine Vielzahl von Datenübertragungsleitungen (DATAL) in dem Randbereich (20) auf mindestens einer Seite des Anzeigebereichs (10) und jeweils elektrisch gekoppelt an die Vielzahl von Datenleitungen (DATA);
eine Vielzahl von ersten Pads (31) und eine Vielzahl von zweiten Pads (32) auf einer Seite der Vielzahl von Datenübertragungsleitungen (DATAL), die von dem Anzeigebereich (10) abgewandt ist, wobei sich die Vielzahl von ersten Pads (31) und die Vielzahl von zweiten Pads (32) jeweils in einer Richtung einer Begrenzung des Anzeigebereichs (10) erstrecken und sich die Vielzahl von zweiten Pads (32) zwischen der Vielzahl von ersten Pads (31) und der Vielzahl von Datenübertragungsleitungen (DATAL) befindet und elektrisch an die Vielzahl von Datenübertragungsleitungen (DATAL) gekoppelt ist, wobei die Vielzahl von ersten Pads (31) konfiguriert ist, um an Eingabesignale einer integrierten Schaltungsvorrichtung elektrisch gekoppelt zu sein, die Vielzahl von zweiten Pads (32) konfiguriert ist, um an Ausgabesignale der integrierten Schaltungsvorrichtung elektrisch gekoppelt zu sein;
eine Vielzahl von dritten Pads (33) zwischen der Vielzahl von ersten Pads (31) und der Vielzahl von zweiten Pads (32), wobei mindestens ein Teil der Vielzahl von dritten Pads (33) an die Vielzahl von zweiten Pads (32) elektrisch gekoppelt sind und die Vielzahl von dritten Pads (33) ferner ein erstes Steueranschlusspad (MUX1) und ein zweites Steueranschlusspad (MUX2) umfassen; und
eine Vielzahl von Multiplexern (42) zwischen der Vielzahl von zweiten Pads (32) und der Vielzahl von dritten Pads (33), wobei mindestens einer der Vielzahl von Multiplexern (42) an mindestens zwei der Vielzahl von zweiten Pads (32) und eines der Vielzahl von dritten Pads (33) elektrisch gekoppelt ist, und mindestens einer der Vielzahl von Multiplexern (42) einen ersten Dünnschichttransistor (T1) und einen zweiten Dünnschichttransistor (T2) umfasst,
wobei das Anzeigesubstrat (100) ferner eine Signalleitung (313) der ersten Ebene und eine Signalleitung (314) der zweiten Ebene zwischen der Vielzahl von ersten Pads (31) und der Vielzahl von dritten Pads (33) umfasst,
wobei die Vielzahl von ersten Pads (31) mindestens ein Eingabepad (311) der ersten Ebene und mindestens ein Eingabepad (312) der zweiten Ebene umfasst, und
wobei das mindestens eine Eingabepad (311) der ersten Ebene durch die Signalleitung (313) der ersten Ebene an das erste Steueranschlusspad (MUX1) elektrisch gekoppelt ist und konfiguriert ist, um ein Signal der ersten Ebene zu empfangen, das den ersten Dünnschichttransistor (T1) in dem Multiplexer (42) ausgeschaltet hält, und das mindestens eine Eingabepad (312) der zweiten Ebene durch die Signalleitung (314) der zweiten Ebene an das zweite Steueranschlusspad (MUX2) elektrisch gekoppelt ist und konfiguriert ist, um ein Signal der zweiten Ebene zu empfangen, das den zweiten Dünnschichttransistor (T2) in dem Multiplexer (42) ausgeschaltet hält,
wobei der erste Dünnschichttransistor (T1) eine erste Source, einen ersten Drain und ein erstes Gate umfasst, der zweite Dünnschichttransistor (T2) eine zweite Source, einen zweiten Drain und ein zweites Gate umfasst; und
wobei eines von der ersten Source und dem ersten Drain und eines von der zweiten Source und dem zweiten Drain an das gleiche Pad in der Vielzahl von dritten Pads (33) elektrisch gekoppelt sind, das andere von der ersten Source und dem ersten Drain an eines der Vielzahl von zweiten Pads (32) elektrisch gekoppelt ist, das andere von der zweiten Source und dem zweiten Drain an ein anderes Pad der Vielzahl von zweiten Pads (32) elektrisch gekoppelt ist; und
wobei das erste Gate an eine erste Steuerleitung (426) elektrisch gekoppelt ist, das zweite Gate an eine zweite Steuerleitung (427) elektrisch gekoppelt ist, die erste Steuerleitung (426) konfiguriert ist, um das Signal der ersten Ebene zu empfangen, die zweite Steuerleitung (427) konfiguriert ist, um das Signal der zweiten Ebene zu empfangen, und das Signal der ersten Ebene und das Signal der zweiten Ebene konfiguriert sind, um das erste Gate und das zweite Gate in dem Multiplexer (42) auszuschalten,
wobei
das erste Steueranschlusspad (MUX1) an die erste Steuerleitung (426) elektrisch gekoppelt ist; und
das zweite Steueranschlusspad (MUX2) an die zweite Steuerleitung (427) elektrisch gekoppelt ist.

2. Anzeigesubstrat (100) nach Anspruch 1, ferner umfassend: einen Verbindungsabschnitt (315) der ersten Ebene und einen Verbindungsabschnitt (316) der zweiten Ebene, wobei eine Anzahl des mindestens einen Eingabepads (311) der ersten Ebene mehrfach ist, und eine Anzahl des mindestens einen Eingabepads (312) der zweiten Ebene mehrfach ist; und
wobei der Verbindungsabschnitt (315) der ersten Ebene zwischen der Vielzahl von Eingabepads (311) der ersten Ebene und der Signalleitung (313') der ersten Ebene liegt und an die Signalleitung (313') der ersten Ebene und die Vielzahl von Eingabepads (311) der ersten Ebene elektrisch gekoppelt ist; und der Verbindungsabschnitt (316) der zweiten Ebene zwischen der Vielzahl von Eingabepads (312) der zweiten Ebene und der Signalleitung (314') der zweiten Ebene liegt und an die Signalleitung (314') der zweiten Ebene und die Vielzahl von Eingabepads (312) der zweiten Ebene elektrisch gekoppelt ist.

3. Anzeigesubstrat (100) nach Anspruch 2, wobei der Verbindungsabschnitt (315) der ersten Ebene und die Signalleitung (313') der ersten Ebene in einer integrierten Struktur vorliegen und der Verbindungsabschnitt (316) der zweiten Ebene und die Signalleitung (314') der zweiten Ebene in einer integrierten Struktur vorliegen.

4. Anzeigesubstrat (100) nach Anspruch 3, wobei die erste Steuerleitung (426), die zweite Steuerleitung (427), die Signalleitung (313') der ersten Ebene, die Signalleitung (314') der zweiten Ebene, das Gate des ersten Dünnschichttransistors (T1) und das Gate des zweiten Dünnschichttransistors (T2) aus einem gleichen Material hergestellt sind und auf einer gleichen Schicht angeordnet sind.

5. Anzeigesubstrat (100) nach einem der Ansprüche 1 bis 4, wobei die Vielzahl von dritten Pads (33) konfiguriert ist, um Testsignale in die Vielzahl von Subpixeln einzugeben, und die Vielzahl von ersten Pads (31) und die Vielzahl von zweiten Pads (32) konfiguriert sind, um mit der gleichen integrierten Schaltungsvorrichtung verbunden zu werden.

6. Anzeigesubstrat (100) nach einem der Ansprüche 1 bis 5, ferner umfassend: eine Signalleitung der dritten Ebene und eine Signalleitung der vierten Ebene; und eine Vielzahl von elektrostatischen Entladungsstrukturen (43), wobei die Signalleitung der dritten Ebene konfiguriert ist, um ein Signal der positiven Ebene bereitzustellen, und die Signalleitung der vierten Ebene konfiguriert ist, um ein Signal der negativen Ebene bereitzustellen, und
wobei mindestens eine der elektrostatischen Entladungsstrukturen (43) umfasst:
einen dritten Dünnschichttransistor (T3), wobei ein Gate des dritten Dünnschichttransistors (T3) an die Signalleitung der dritten Ebene elektrisch gekoppelt ist, eines von einer Source und einem Drain des dritten Dünnschichttransistors (T3) an die Signalleitung der dritten Ebene elektrisch gekoppelt ist und das andere von der Source und dem Drain des dritten Dünnschichttransistors an ein entsprechendes Pad in der Vielzahl von dritten Pads (33) elektrisch gekoppelt ist;
einen vierten Dünnschichttransistor (T4), wobei ein Gate des vierten Dünnschichttransistors (T4) an die Signalleitung der dritten Ebene elektrisch gekoppelt ist, eines von einer Source und einem Drain des vierten Dünnschichttransistors (T4) an die Signalleitung der dritten Ebene elektrisch gekoppelt ist und das andere von der Source und dem Drain des vierten Dünnschichttransistors (T4) an ein entsprechendes Pad in der Vielzahl von dritten Pads (33) elektrisch gekoppelt ist;
einen fünften Dünnschichttransistor (T5), wobei ein Gate des fünften Dünnschichttransistors (T5) an ein entsprechendes Pad in der Vielzahl von dritten Pads (33) elektrisch gekoppelt ist, eines von einer Source und einem Drain des fünften Dünnschichttransistors (T5) an die Signalleitung der vierten Ebene elektrisch gekoppelt ist und das andere von der Source und dem Drain des fünften Dünnschichttransistors (T5) an ein entsprechendes Pad in der Vielzahl von dritten Pads (33) elektrisch gekoppelt ist; und
einen sechsten Dünnschichttransistor (T6), wobei ein Gate des sechsten Dünnschichttransistors (T6) an ein entsprechendes Pad in der Vielzahl von dritten Pads (33) elektrisch gekoppelt ist, eines von einer Source und einem Drain des sechsten Dünnschichttransistors (T6) an die Signalleitung der vierten Ebene elektrisch gekoppelt ist und das andere von der Source und dem Drain des sechsten Dünnschichttransistors (T6) elektrisch an ein entsprechendes Pad in der Vielzahl von dritten Pads (33) gekoppelt ist.

7. Anzeigesubstrat (100) nach Anspruch 6, wobei sowohl der dritte Dünnschichttransistor (T3) als auch der vierte Dünnschichttransistor (T4) eine aktive Schicht umfasst; und
wobei das Gate des dritten Dünnschichttransistors (T3) und das Gate des vierten Dünnschichttransistors (T4) ein erstes stabförmiges Sub-Gate und ein zweites stabförmiges Sub-Gate umfassen; und
wobei eines von der Source und dem Drain jedes des dritten Dünnschichttransistors (T3) und des vierten Dünnschichttransistors (T4) einen ersten Armabschnitt (63) und einen zweiten Armabschnitt (64) aufweist, die aneinander gekoppelt sind, sich der erste Armabschnitt (63) in einer ersten Richtung erstreckt und sich der zweite Armabschnitt (64) in einer zweiten Richtung erstreckt, die die erste Richtung kreuzt, der erste Armabschnitt (63) durch ein erstes Kontaktloch an die aktive Schicht gekoppelt ist und der zweite Armabschnitt (64) durch eine zweite Kontaktlochstruktur an das erste stabförmige Sub-Gate gekoppelt ist und durch ein drittes Kontaktloch an das zweite stabförmige Sub-Gate gekoppelt ist; und
wobei die elektrostatische Entladungsstruktur (43) ferner umfasst: einen ersten Verbindungsabschnitt (61) und einen zweiten Verbindungsabschnitt (62); und
wobei der erste Verbindungsabschnitt (61) und die aktive Schicht aus einem gleichen Material hergestellt sind und auf einer gleichen Schicht angeordnet sind, und der zweite Verbindungsabschnitt (62) und die Source und der Drain aus einem gleichen Material hergestellt sind und auf einer gleichen Schicht angeordnet sind; und
wobei der erste Verbindungsabschnitt (61) an eines von der Source und dem Drain jedes des dritten Dünnschichttransistors (T3) und des vierten Dünnschichttransistors (T4) durch die dritte Kontaktlochstruktur gekoppelt ist, der erste Verbindungsabschnitt (61) an den zweiten Verbindungsabschnitt (62) durch ein viertes Kontaktloch gekoppelt ist und der zweite Verbindungsabschnitt (62) an die Signalleitung der dritten Ebene durch eine fünfte Kontaktlochstruktur gekoppelt ist.

8. Anzeigesubstrat (100) nach einem der Ansprüche 2 bis 4, wobei mindestens eine der Vielzahl von Subpixeleinheiten (PIX) eine Pixelschaltung (560) und ein lichtemittierendes Element (550) umfasst, wobei die Pixelschaltung (560) zwischen dem Basissubstrat (1) und dem lichtemittierenden Element (550) liegt; und
wobei das lichtemittierende Element (550) eine erste Elektrode (553), eine lichtemittierende Schicht (552) und eine zweite Elektrode (551) umfasst, die nacheinander gestapelt sind, und sich die zweite Elektrode (551) auf einer Seite der lichtemittierenden Schicht befindet, die dem Basissubstrat (1) zugewandt ist; und
wobei die Pixelschaltung (560) mindestens einen Dünnschichttransistor umfasst, der Dünnschichttransistor ein Gate auf dem Basissubstrat (1), eine Source und einen Drain auf einer von dem Basissubstrat (1) abgewandten Seite des Gates umfasst, und die Source oder der Drain des Dünnschichttransistors an die zweite Elektrode (551) elektrisch gekoppelt ist; und
die Source und der Drain des mindestens einen Dünnschichttransistors auf einer gleichen Schicht mit der Vielzahl von ersten Pads (31), der Vielzahl von zweiten Pads (32) und der Vielzahl von dritten Pads (33) angeordnet sind; und
wobei sich der Verbindungsabschnitt (315) der ersten Ebene, die Signalleitung (313') der ersten Ebene, der Verbindungsabschnitt (316) der zweiten Ebene, die Signalleitung (314') der zweiten Ebene und das Gate des Dünnschichttransistors in der Pixelschaltung (560) auf einer gleichen Schicht befinden.

9. Anzeigesubstrat (100) nach einem der Ansprüche 1 bis 8, wobei das Anzeigesubstrat (100) ein biegbares Substrat ist, das Anzeigesubstrat (100) einen biegbaren Bereich (30) umfasst und die Vielzahl von zweiten Pads (32) weiter von dem Anzeigebereich (10) entfernt sind als der biegbare Bereich (30).

10. Anzeigeeinrichtung, umfassend:
das Anzeigesubstrat (100) nach einem der Ansprüche 1 bis 9; und
eine integrierte Schaltungsvorrichtung (400), wobei die integrierte Schaltungsvorrichtung (400) mit der Vielzahl von ersten Pads (31) und der Vielzahl von zweiten Pads (32) verbunden ist.

11. Anzeigeeinrichtung nach Anspruch 10, wobei eine orthografische Projektion der integrierten Schaltungsvorrichtung (400) auf das Basissubstrat (1) orthografische Projektionen der Vielzahl von dritten Pads (33) auf das Basissubstrat (1) mindestens teilweise überlappt.

## Revendications

1. Substrat d'affichage (100), comprenant :
un substrat de base (1) comprenant une zone d'affichage (10) et une zone périphérique (20) entourant la zone d'affichage (10) ;
une pluralité d'unités de sous-pixel (PIX) dans la zone d'affichage (10) ;
une pluralité de lignes de données (DATA) dans la zone d'affichage (10) et couplées électriquement à la pluralité d'unités de sous-pixels (PIX), respectivement ;
une pluralité de lignes de transmission de données (DATAL) dans la zone périphérique (20) sur au moins un côté de la zone d'affichage (10) et couplées électriquement à la pluralité de lignes de données (DATA), respectivement ;
une pluralité de premiers plots (31) et une pluralité de deuxièmes plots (32) sur un côté de la pluralité de lignes de transmission de données (DATAL) éloigné de la zone d'affichage (10), dans lequel la pluralité de premiers plots (31) et la pluralité de deuxièmes plots (32) s'étendent dans une direction d'une limite de la zone d'affichage (10), respectivement, et la pluralité de deuxièmes plots (32) sont situés entre la pluralité de premiers plots (31) et la pluralité de lignes de transmission de données (DATAL) et sont couplés électriquement à la pluralité de lignes de transmission de données (DATAL), dans lequel la pluralité de premiers plots (31) sont configurés pour être couplés électriquement à des signaux d'entrée d'un dispositif à circuit intégré, la pluralité de deuxièmes plots (32) sont configurés pour être couplés électriquement à des signaux de sortie du dispositif à circuit intégré ;
une pluralité de troisièmes plots (33) entre la pluralité de premiers plots (31) et la pluralité de deuxièmes plots (32), dans lequel au moins une part de la pluralité de troisièmes plots (33) est couplée électriquement à la pluralité de deuxièmes plots (32), et la pluralité de troisièmes plots (33) comprennent en outre un premier plot de borne de commande (MUX1) et un second plot de borne de commande (MUX2) ; et
une pluralité de multiplexeurs (42) entre la pluralité de deuxièmes plots (32) et la pluralité de troisièmes plots (33), dans lequel au moins l'un parmi la pluralité de multiplexeurs (42) est couplé électriquement à au moins deux parmi la pluralité de deuxièmes plots (32) et à l'un parmi la pluralité de troisièmes plots (33), et au moins l'un parmi la pluralité de multiplexeurs (42) comprend un premier transistor à couches minces (T1) et un deuxième transistor à couches minces (T2),
dans lequel le substrat d'affichage (100) comprend en outre une ligne de signal de premier niveau (313) et une ligne de signal de deuxième niveau (314) entre la pluralité de premiers plots (31) et la pluralité de troisièmes plots (33),
dans lequel la pluralité de premiers plots (31) comprennent au moins un plot d'entrée de premier niveau (311) et au moins un plot d'entrée de deuxième niveau (312), et
dans lequel l'au moins un plot d'entrée de premier niveau (311) est couplé électriquement au premier plot de borne de commande (MUX1) par le biais de la ligne de signal de premier niveau (313) et est configuré pour recevoir un signal de premier niveau qui maintient le premier transistor à couches minces (T1) dans le multiplexeur (42) à l'état bloqué, et l'au moins un plot d'entrée de deuxième niveau (312) est couplé électriquement au second plot de borne de commande (MUX2) par le biais de la ligne de signal de deuxième niveau (314) et est configuré pour recevoir un signal de deuxième niveau qui maintient le second transistor à couches minces (T2) dans le multiplexeur (42) à l'état bloqué,
dans lequel le premier transistor à couches minces (T1) comprend une première source, un premier drain et une première grille, le deuxième transistor à couches minces (T2) comprend une seconde source, un second drain et une seconde grille ; et
dans lequel l'un parmi la première source et le premier drain et l'un parmi la seconde source et le second drain sont couplés électriquement à un même plot de la pluralité de troisièmes plots (33), l'autre parmi la première source et le premier drain est couplé électriquement à l'un parmi la pluralité de deuxièmes plots (32), l'autre parmi la seconde source et le second drain est couplé électriquement à un autre plot parmi la pluralité de deuxièmes plots (32) ; et
dans lequel la première grille est couplée électriquement à une première ligne de commande (426), la seconde grille est couplée électriquement à une seconde ligne de commande (427), la première ligne de commande (426) est configurée pour recevoir le signal de premier niveau, la seconde ligne de commande (427) est configurée pour recevoir le signal de deuxième niveau, et le signal de premier niveau et le signal de deuxième niveau sont configurés pour désactiver la première porte et la seconde grille dans le multiplexeur (42),
dans laquelle
le premier plot de borne de commande (MUX1) est couplé électriquement à la première ligne de commande (426) ; et
le deuxième plot de borne de commande (MUX2) est couplé électriquement à la seconde grille de commande (427).

2. Substrat d'affichage (100) selon la revendication 1, comprenant en outre : une partie de connexion de premier niveau (315) et une partie de connexion de deuxième niveau (316), dans lequel un nombre de l'au moins un plot d'entrée de premier niveau (311) est multiple, et un nombre de l'au moins un plot d'entrée de deuxième niveau (312) est multiple ; et
dans lequel la partie de connexion de premier niveau (315) est située entre la pluralité de plots d'entrée de premier niveau (311) et la ligne de signal de premier niveau (313'), et est couplée électriquement à la ligne de signal de premier niveau (313') et à la pluralité de plots d'entrée de premier niveau (311) ; et la partie de connexion de deuxième niveau (316) est située entre la pluralité de plots d'entrée de deuxième niveau (312) et la ligne de signal de deuxième niveau (314'), et est couplée électriquement à la ligne de signal de deuxième niveau (314') et à la pluralité de plots d'entrée de deuxième niveau (312).

3. Substrat d'affichage (100) selon la revendication 2, dans lequel la partie de connexion de premier niveau (315) et la ligne de signal de premier niveau (313') sont en une structure intégrée, et la partie de connexion de deuxième niveau (316) et la ligne de signal de deuxième niveau (314') sont en une structure intégrée.

4. Substrat d'affichage (100) selon la revendication 3, dans lequel la première ligne de commande (426), la deuxième ligne de commande (427), la première ligne de signal de niveau (313'), la deuxième ligne de signal de niveau (314'), la grille du premier transistor à couches minces (T1) et la grille du deuxième transistor à couches minces (T2) sont constituées d'un même matériau et sont agencées sur une même couche.

5. Substrat d'affichage (100) selon l'une quelconque des revendications 1 à 4, dans lequel la pluralité de troisièmes plots (33) sont configurés pour introduire des signaux de test à la pluralité de sous-pixels, et la pluralité de premiers plots (31) et la pluralité de deuxièmes plots (32) sont configurés pour être liés au même dispositif à circuit intégré.

6. Substrat d'affichage (100) selon l'une quelconque des revendications 1 à 5, comprenant en outre : une ligne de signal de troisième niveau et une ligne de signal de quatrième niveau ; et une pluralité de structures de décharge électrostatique (43), dans lequel la ligne de signal de troisième niveau est configurée pour fournir un signal de niveau positif, et la ligne de signal de quatrième niveau est configurée pour fournir un signal de niveau négatif, et
dans lequel au moins l'une des structures de décharge électrostatique (43) comprend :
un troisième transistor à couches minces (T3), dans lequel une grille du troisième transistor à couches minces (T3) est couplée électriquement à la ligne de signal de troisième niveau, l'un parmi une source et un drain du troisième transistor à couches minces (T3) est couplé électriquement à la ligne de signal de troisième niveau, et l'autre parmi la source et le drain du troisième transistor à couches minces est couplé électriquement à un plot correspondant dans la pluralité de troisièmes plots (33) ;
un quatrième transistor à couches minces (T4), dans lequel une grille du quatrième transistor à couches minces (T4) est couplée électriquement à la ligne de signal de troisième niveau, l'un parmi une source et un drain du quatrième transistor à couches minces (T4) est couplé électriquement à la ligne de signal de troisième niveau, et l'autre parmi la source et le drain du quatrième transistor à couches minces (T4) est couplé électriquement à un plot correspondant dans la pluralité de troisièmes plots (33) ;
un cinquième transistor à couches minces (T5), dans lequel une grille du cinquième transistor à couches minces (T5) est couplée électriquement à un plot correspondant dans la pluralité de troisièmes plots (33), l'un parmi une source et un drain du cinquième transistor à couches minces (T5) est couplé électriquement à la ligne de signal de quatrième niveau, et l'autre parmi la source et le drain du cinquième transistor à couches minces (T5) est couplé électriquement à un plot correspondant dans la pluralité de troisièmes plots (33) ; et
un sixième transistor à couches minces (T6), dans lequel une grille du sixième transistor à couches minces (T6) est couplée électriquement à un plot correspondant dans la pluralité de troisièmes plots (33), l'un parmi une source et un drain du sixième transistor à couches minces (T6) est couplé électriquement à la ligne de signal de quatrième niveau, et l'autre parmi la source et le drain du sixième transistor à couches minces (T6) est couplé électriquement à un plot correspondant dans la pluralité de troisièmes plots (33).

7. Substrat d'affichage (100) selon la revendication 6, dans lequel le troisième transistor à couches minces (T3) et le quatrième transistor à couches minces (T4) comprennent tous deux une couche active ; et
dans lequel la grille du troisième transistor à couches minces (T3) et la grille du quatrième transistor à couches minces (T4) comprennent une première sous-grille en forme de barre et une seconde sous-grille en forme de barre ; et
dans lequel l'un parmi la source et le drain de chacun du troisième transistor à couches minces (T3) et du quatrième transistor à couches minces (T4) présente une première partie de bras (63) et une seconde partie de bras (64) couplées l'une à l'autre, la première partie de bras (63) s'étend dans une première direction, et la seconde partie de bras (64) s'étend dans une seconde direction croisant la première direction, la première partie de bras (63) est couplée à la couche active par le biais d'un premier trou d'interconnexion, et la seconde partie de bras (64) est couplée à la première sous-grille en forme de barre par le biais d'une deuxième structure de trou d'interconnexion et est couplée à la seconde sous-grille en forme de barre par l'intermédiaire d'un troisième trou d'interconnexion ; et
dans lequel la structure de décharge électrostatique (43) comprend en outre : une première partie de connexion (61) et une seconde partie de connexion (62) ; et
dans lequel la première partie de connexion (61) et la couche active sont constituées d'un même matériau et sont agencées sur une même couche, et la seconde partie de connexion (62) et la source et le drain sont constitués d'un même matériau et sont disposés sur une même couche ; et
dans lequel la première partie de connexion (61) est couplée à l'un parmi la source et le drain de chacun du troisième transistor à couches minces (T3) et la quatrième transistor à couches minces (T4) par le biais de la troisième structure de trou d'interconnexion, la première partie de connexion (61) est couplée à la seconde partie de connexion (62) par le biais d'un quatrième trou d'interconnexion, et la seconde partie de connexion (62) est couplée à la ligne de signal de troisième niveau par l'intermédiaire d'une cinquième structure de trou d'interconnexion.

8. Substrat d'affichage (100) selon l'une quelconque des revendications 2 à 4, dans lequel au moins l'une parmi la pluralité d'unités de sous-pixel (PIX) comprend un circuit de pixel (560) et un élément photoémetteur (550), le circuit de pixel (560) est entre le substrat de base (1) et l'élément photoémetteur (550) ; et
dans lequel l'élément photoémetteur (550) comprend une première électrode (553), une couche photoémettrice (552) et une seconde électrode (551) empilées en séquence, et la seconde électrode (551) est située sur un côté de la couche photoémettrice faisant face au substrat de base (1) ; et
dans lequel le circuit de pixel (560) comprend au moins un transistor à couches minces, le transistor à couches minces comprend une grille sur le substrat de base (1), une source et un drain sur un côté de la grille à l'opposé du substrat de base (1), et la source ou le drain du transistor à couches minces est couplé électriquement à la seconde électrode (551) ; et
la source et le drain de l'au moins un transistor à couches minces sont agencés sur une même couche que la pluralité de premiers plots (31), la pluralité de deuxièmes plots (32) et la pluralité de troisièmes plots (33) ; et
dans lequel la partie de connexion de premier niveau (315), la ligne de signal de premier niveau (313'), la partie de connexion de deuxième niveau (316), la ligne de signal de deuxième niveau (314') et la grille du transistor à couches minces dans le circuit de pixel (560) sont situées sur une même couche.

9. Substrat d'affichage (100) selon l'une quelconque des revendications 1 à 8, dans lequel le substrat d'affichage (100) est un substrat pliable, le substrat d'affichage (100) comprend une zone pliable (30), et la pluralité de deuxièmes plots (32) sont plus éloignés de la zone d'affichage (10) que la zone pliable (30).

10. Appareil d'affichage, comprenant :
le substrat d'affichage (100) selon l'une quelconque des revendications 1 à 9 ; et
un dispositif de circuit intégré (400), dans lequel le dispositif de circuit intégré (400) est lié à la pluralité de premiers plots (31) et à la pluralité de deuxièmes plots (32).

11. Appareil d'affichage selon la revendication 10, dans lequel une projection orthographique du dispositif à circuit intégré (400) sur le substrat de base (1) chevauche au moins partiellement des projections orthographiques de la pluralité de troisièmes plots (33) sur le substrat de base (1).
